# FASCICULE DE BREVET EUROPEEN

(11) **EP 2 491 415 B1**
(45) Date de publication et mention de la délivrance du brevet: **12.02.2014**
(21) Numéro de dépôt: 10774165.4
(22) Date de dépôt: 18.10.2010
(51) Int. Cl.: G01R 31/36

(54) **DISPOSITIF DE MESURE DE TENSION POUR BATTERIE ET DISPOSITIF DE CONTRÔLE ASSOCIÉ**
VORRICHTUNG ZUR MESSUNG DER BATTERIESPANNUNG UND ZUGEHÖRIGE ÜBERWACHUNGSVORRICHTUNG
DEVICE FOR MEASURING BATTERY VOLTAGE AND RELATED MONITORING DEVICE

(30) Priorité: 19.10.2009 FR 0905005
(43) Date de publication de la demande: 29.08.2012
(73) Titulaire: Commissariat à l'Énergie Atomique et aux Énergies Alternatives, 75015 Paris (FR)
(72) Inventeur: DAUCHY, Julien, F-38160 Chatte (FR); CHATROUX, Daniel, F-38470 Teche (FR)
(74) Mandataire: Croonenbroek, Thomas Jakob
(86) Numéro de dépôt international: PCT/EP2010/065660
(87) Numéro de publication internationale: WO 2011/048062

(56) Documents cités:
- JP-A- 10 312 829
- US-A- 5 546 003
- US-A1- 2007 290 674
- US-B1- 6 278 280

## Description

L'invention concerne un dispositif de mesure pour des batteries d'accumulateurs électrochimiques, pouvant être utilisées notamment dans le domaine des transports électriques, hybrides et les systèmes embarqués.

L'invention concerne en particulier les batteries de type lithium-ion (Li-ion) bien adaptées pour ce genre d'applications, du fait de leur possibilité de stocker une forte énergie avec une faible masse.

On appelle batterie d'accumulateurs la mise en série de plusieurs accumulateurs ou d'accumulateurs en parallèles. US 2007/0290674 décrit une telle batterie.

La charge d'un accumulateur se traduit par une croissance de la tension à ses bornes. On considère un accumulateur chargé lorsque celui-ci a atteint un niveau de tension défini par le processus électrochimique.

En outre, les batteries de technologie lithium-ion présentent une tension de seuil minimale en dessous de laquelle les accumulateurs de la batterie peuvent être détériorés ou détruits, ce qui peut entraîner un mauvais fonctionnement de la batterie, par exemple le courant est bloqué et la batterie ne délivre plus aucune énergie.

De plus, dans un circuit utilisant plusieurs accumulateurs mis en série, il est fortement probable que le niveau de charge de chaque accumulateur ne soit pas le même. En effet, il est possible qu'un accumulateur soit déchargé avant les autres accumulateurs de la batterie.

En conséquence, il faut arrêter la décharge de la batterie lorsque la tension de l'accumulateur le moins chargé descend en dessous de la tension de seuil minimale, même s'il reste de l'énergie dans les autres accumulateurs pour éviter un mauvais fonctionnement de la batterie et la détérioration de l'accumulateur le moins chargé.

Il est alors obligatoire de surveiller en détail la tension de chaque accumulateur lors de la décharge pour vérifier qu'aucun accumulateur n'atteigne la tension de seuil minimale.

L'invention a donc pour objectif de permettre de surveiller de façon simple la tension de chaque accumulateur de façon à éviter qu'un accumulateur ne descende en dessous de la tension de seuil minimale afin d'empêcher la détérioration de l'accumulateur et donc le mauvais fonctionnement de la batterie.

À cet effet, l'invention a pour objet un dispositif de mesure de tension pour batterie comprenant un accumulateur, caractérisé en ce que ledit dispositif de mesure comporte :
- un générateur de courant alternatif,
- au moins une première et au moins une seconde diodes mises en série, telles que ladite première diode soit reliée au pôle positif dudit accumulateur par sa cathode et à la cathode de ladite seconde diode par son anode, et ladite seconde diode soit reliée au pôle négatif dudit accumulateur par son anode et à l'anode de ladite première diode par sa cathode,
- un condensateur de lecture relié au générateur de courant alternatif et au point milieu entre lesdites première et seconde diodes, et à un moyen de détermination de la tension aux bornes dudit accumulateur à partir de la variation de tension au point milieu, ledit moyen de détermination comportant :
   - une troisième et une quatrième diodes de redressement en série telles que l'anode de la troisième diode de redressement soit reliée à la cathode de la quatrième diode de redressement et audit condensateur de lecture,
   - un condensateur de filtrage relié d'une part à la cathode de la troisième diode de redressement et à l'anode de la quatrième diode de redressement,
   - une résistance montée en parallèle du condensateur de filtrage.

Un tel dispositif de mesure de tension comporte par accumulateur deux diodes et un condensateur, qui sont des composants simples à mettre en oeuvre et permettent donc de réaliser des circuits peu complexes à moindre coût, sans présenter une masse ni un volume trop important, pour surveiller qu'aucun accumulateur de la batterie n'atteigne une tension inférieure à une tension de seuil minimale prédéfinie.

Ledit dispositif de mesure peut en outre comporter une ou plusieurs caractéristiques suivantes, prises séparément ou en combinaison :
- lesdites première et seconde diodes présentent une tension de seuil sensiblement égale à 0,6 V,
- ledit dispositif de mesure comporte en outre un condensateur d'injection relié au générateur de courant et au point milieu,
- ledit dispositif de mesure est un dispositif de mesure de tensions pour batterie comportant au moins deux accumulateurs en série, et ledit dispositif comporte un dispositif de mesure pour un des accumulateurs, une première et une seconde diodes en parallèle de chaque accumulateur, une pluralité de condensateurs de liaison reliant respectivement deux points milieu consécutifs, ladite pluralité de condensateurs de liaison étant montés en série, le moyen de détermination déterminant la tension la plus faible aux bornes des accumulateurs,
- ledit dispositif de mesure comporte en outre un condensateur d'injection relié au générateur de courant alternatif d'une part et à un point milieu quelconque d'autre part ,
- les troisième et quatrième diodes de redressement sont configurées pour soustraire les tensions de seuil desdites première et seconde diodes du signal de tension traversant lesdites troisième et quatrième diodes de redressement, de manière à ne conserver que l'information de tension relative à l'accumulateur,
- ledit dispositif de mesure comporte au moins un condensateur de rappel monté en parallèle d'un nombre prédéterminé des condensateurs de liaison,
- le générateur de courant alternatif est réalisé par un générateur de tension et une résistance montés en série, ledit générateur de tension générant un signal carré de fréquence de 100kHz et d'amplitude de 0 à 10 V.

L'invention concerne encore un dispositif de contrôle comprenant un dispositif de mesure selon l'invention, caractérisé en ce qu'il comprend un moyen de comparaison de la tension mesurée dudit accumulateur à une tension de seuil prédéfinie et un dispositif de commande pour arrêter la décharge de la batterie lorsque ladite tension mesurée est inférieure à la tension de seuil prédéfinie.

L'invention concerne également une batterie d'accumulateurs intégrant un tel dispositif de contrôle

Cette batterie est par exemple une batterie lithium-ion.

D'autres caractéristiques et avantages de l'invention ressortiront de la description suivante, donnée à titre d'exemple, sans caractère limitatif, en regard des dessins annexés parmi lesquels :
- la figure 1 représente de façon schématique un dispositif de mesure de la tension d'un accumulateur d'une batterie,
- la figure 2 illustre schématiquement un dispositif de mesure de la tension de deux accumulateurs d'une batterie, et
- la figure 3 représente de façon schématique un dispositif de mesure de la tension de plusieurs accumulateurs en série d'une batterie comprenant des condensateurs de rappel.

Dans ces figures, les éléments identiques portent les mêmes références.

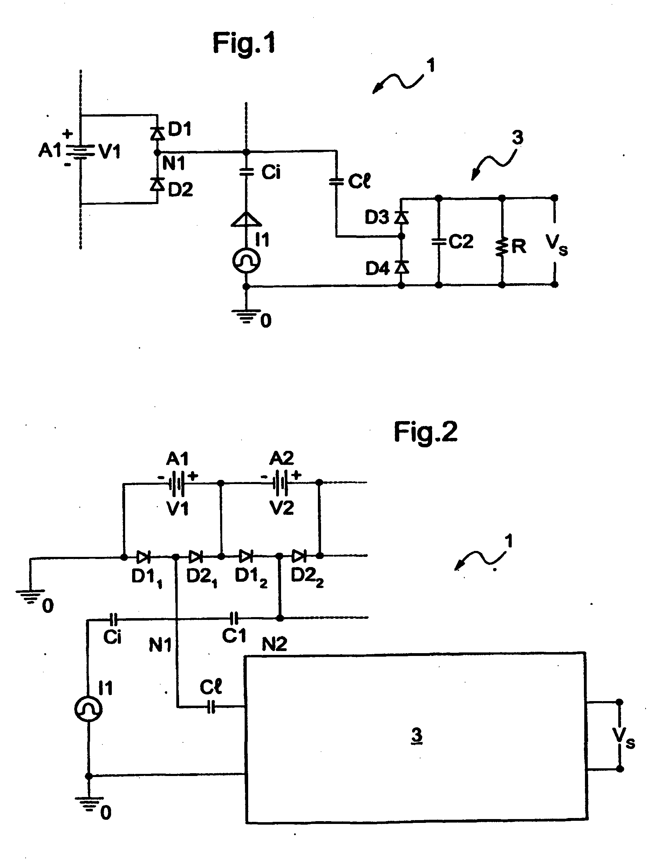

La figure 1 illustre un mode de réalisation d'un dispositif de mesure 1 de tension pour batterie d'accumulateur permettant de mesurer la tension d'un accumulateur Ai, ici A1, dé la batterie.

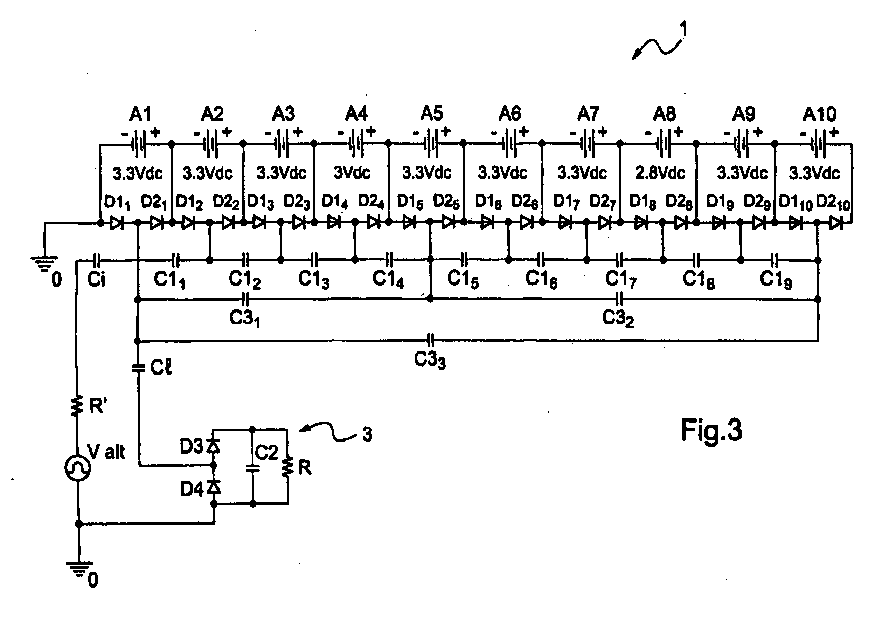

Le dispositif de mesure 1 comprend :
- un générateur de courant alternatif I1, ou en variante un générateur de tension générant par exemple un signal carré de fréquence de 100kHz et d'amplitude de 0 à 10 V et une résistance R' en série (figure 3),
- une première D1 et une seconde D2 diodes mises en série (figure 1),
- un condensateur de lecture C1 relié au point milieu N entre les première D1 et seconde D2 diodes, et à un moyen de détermination 3 pour déterminer la tension aux bornes de l'accumulateur A1 à partir de la variation de tension au point milieu N.

Comme on le constate sur la figure 1, la première diode D1 est reliée au pôle positif + de l'accumulateur A1 par sa cathode et à la cathode de la seconde diode D2 par son anode, et la seconde diode D2 est reliée au pôle négatif - de l'accumulateur A1 par son anode et à l'anode de la première diode D1 par sa cathode.

Lors de l'alternance positive du courant I1, la première diode D1 est passante et la seconde diode D2 est bloquée. Le courant I1 traverse alors la première diode D1. La tension au point milieu N est alors égale à la somme de la tension de l'accumulateur A1 sur le pôle positif + avec la tension de seuil de la première diode D1.

Au contraire, lors de l'alternance négative, c'est la seconde diode D2 qui est passante et la première diode D1 qui est bloquée. Le courant traverse alors la seconde diode D2. La tension au point milieu N est alors égale à la somme de la tension sur le pôle négatif - de l'accumulateur A1 avec la tension de seuil de la seconde diode D2.

En conséquence, la variation de tension au point milieu N est égale à la somme de la tension V1 de l'accumulateur A1 avec les tensions de seuil des première D1 et seconde D2 diodes.

À titre d'exemple, les première D1 et seconde D2 diodes présentent une tension de seuil de 0,6 V. Pour une tension V1 par exemple de 2,6 V de l'accumulateur A1, la variation de tension au point milieu N est donc égale à 3,8 V.

Le signal de tension qui arrive au condensateur de lecture Cl est un signal présentant une amplitude de variation du signal qui correspond à la variation de tension au point milieu N et une composante continue.

Le condensateur de lecture C1 permet de supprimer la composante continue de façon à avoir uniquement une information sur l'amplitude de variation du signal.

Par ailleurs, dans l'exemple illustré, le moyen de détermination 3 comprend :
- une troisième D3 et une quatrième D4 diodes de redressement en série telles que l'anode de la troisième diode D3 de redressement soit reliée à la cathode de la quatrième diode D4 de redressement et au condensateur de lecture Cl,
- un condensateur C2 de filtrage relié d'une part à la cathode de la troisième diode D3 de redressement et à l'anode de la quatrième diode D4 de redressement, et
- une résistance R montée en parallèle du condensateur C2 de filtrage.

Le passage du signal de tension dans les deux diodes D3 et D4 de redressement permet de redresser ce signal pour obtenir un signal de signe constant et permet également de soustraire les tensions de seuil des première D1 et seconde D2 diodes.

Le signal est ensuite filtré avec le condensateur de filtrage C2 ce qui permet d'obtenir une tension sensiblement continue.

La tension Vs mesurée aux bornes de la résistance R est alors sensiblement égale à la tension V1 aux bornes de l'accumulateur A1.

Un tel dispositif de mesure fait partie d'un dispositif de contrôle de tension pour batterie.

La tension Vs peut ensuite être transmise à un comparateur du dispositif de contrôle (non représenté) qui compare la tension Vs mesurée à une tension de seuil prédéfinie, et lorsque la tension Vs mesurée est inférieure à la tension de seuil, un dispositif de commande du dispositif de contrôle arrête la décharge de la batterie par exemple en déconnectant la batterie du système de décharge dans lequel elle est implantée.

En outre, pour plus de précision, on peut prévoir un condensateur d'injection Ci relié au point milieu N, et au générateur de courant I1.

Les figures 2 et 3 illustrent un second mode de réalisation dans lequel le dispositif de mesure permet de surveiller la tension de chaque accumulateur Ak d'une batterie comprenant plusieurs accumulateurs Ak mis en série.

Dans l'exemple de la figure 2, on a représenté deux accumulateurs A1 et A2 mis en série.

En parallèle de chaque accumulateur A1,A2, une première et une seconde diodes sont prévues D1₁,D2₁ respectivement D1₂,D2₂. Un condensateur de liaison C1 relie les deux points milieu N₁ et N₂, respectivement entre les deux diodes D1₁,D2₁, et les deux diodes D1₂,D2₂, et un condensateur de lecture Cl est relié au moyen de détermination 3 et au point milieu N₁ ou indifféremment au point milieu N₂ entre les diodes D1₂ et D2₂ au lieu du point milieu N₁. On retrouve donc le dispositif de mesure de la figure 1 pour un Aj des accumulateurs, dans l'exemple illustré sur la figure 2 pour l'accumulateur A1.

À titre d'exemple, l'accumulateur A1 présente une tension V1 inférieure à la tension V2 de l'accumulateur A2. Dans ce cas, lors de l'alternance positive du courant I1, c'est la première diode D1₁ de l'accumulateur A1 qui est passante et la seconde diode D2₁ de l'accumulateur A1 qui est bloquée, et le courant I1 traverse la première diode D1₁. Et, lors de l'alternance négative, c'est la seconde diode D2₁ de l'accumulateur A1 qui est passante et la première diode D1₁ de l'accumulateur A1 qui est bloquée, et le courant I1 traverse la seconde diode D2₁.

L'amplitude de la tension présente sur les points milieu est identique sur tous les points milieu N₁, N₂, seule la composante continue du signal est différente. Cette amplitude de tension est égale à la somme de la tension de l'accumulateur A1 ayant la tension la plus faible avec les tensions de seuil des première D1₁ et seconde D2₁ diodes.

La mesure de la tension de l'accumulateur A1 ayant la plus faible tension se fait donc sur l'un quelconque des points milieu N₁,N₂ à l'aide du moyen de détermination 3.

En outre, en absorbant du courant, l'accumulateur A1 ayant la plus faible tension se charge. De ce fait, sa tension augmente jusqu'à atteindre la tension de l'accumulateur A2 qui est plus chargé. On équilibre ainsi les accumulateurs de la batterie.

Le dispositif de mesure 1 peut comporter en outre un condensateur Ci d'injection relié au générateur de courant alternatif I1 et à point milieu Nₖ quelconque, ici le point milieu N₁ entre les diodes D1₁ et D2₁ associées à l'accumulateur A1.

Dans l'exemple de la figure 3, le dispositif de mesure 1 permet de surveiller la tension de 10 accumulateurs Ak (1≤k≤10) en série d'une batterie.

Neuf condensateurs de liaison C1m où m varie de 1 à 9 dans cet exemple, relient respectivement deux points milieu consécutifs et sont montés en série.

On peut prévoir en outre un condensateur Ci d'injection relié d'une part au générateur de courant alternatif et d'autre part à un point milieu quelconque.

Le condensateur de lecture Cl est quant à lui relié à un point milieu quelconque, ici le premier point milieu, et au moyen de détermination 3.

Prenons le cas où l'accumulateur A8 présente la plus faible tension, par exemple 2,6 V alors que les autres accumulateurs A1 à A7, A9 et A10 présentent une tension supérieure à 2,6 V, par exemple de l'ordre de 3V pour l'accumulateur A4 ou 3,3 V pour les autres accumulateurs.

Comme précédemment, l'amplitude de la tension présente sur les points milieu est identique sur tous les points milieu et est égale à la somme de la tension de l'accumulateur A8 ayant la tension la plus faible avec les tensions de seuil des première D1₈ et seconde D2₈ diodes.

Le moyen de détermination 3 peut alors déterminer la tension aux bornes de l'accumulateur A8 à partir de cette variation de tension, par exemple à l'aide des troisième D3 et quatrième D4 diodes de redressement et du condensateur C2 de filtrage tel que décrit précédemment.

De plus, en absorbant du courant, l'accumulateur A8 ayant la plus faible tension se charge, et sa tension augmente jusqu'à atteindre la tension du second accumulateur le plus déchargé, c'est à dire ayant la seconde tension plus faible, dans l'exemple illustré sur la figure 3 c'est l'accumulateur A4 présentant une tension de l'ordre de 3V qui est le second accumulateur le plus déchargé. Ainsi de suite, plusieurs accumulateurs parmi les plus déchargés avec des tensions voisines vont se charger simultanément jusqu'à atteindre la tension du troisième élément le plus déchargé, jusqu'à ce que tous les accumulateurs aient une tension identique, par exemple ici 3,3 V.

En outre, afin de garantir que tous les points milieu ont la même variation de tension de manière à pouvoir mesurer la tension de l'accumulateur le moins chargé, c'est à dire ayant la plus faible tension, quelle que soit sa position, on peut ajouter des condensateurs de rappel C3₁ à C3₃ en parallèle des condensateurs de liaison C1₁ à C1₉. Dans l'exemple illustré sur la figure 3, le condensateur de rappel C3₁ est monté en parallèle des condensateurs C1₁ à C1₄, le condensateur de rappel C3₂ est monté en parallèle des condensateurs C1₅ à C1₉, et le condensateur de rappel C3₃ est monté en parallèle des condensateurs C1₁ à C1₉.

Les composants d'un tel dispositif de mesure sont donc simples à mettre en oeuvre et peu coûteux, pour savoir de façon simple lorsqu'un accumulateur franchit la tension minimale de seuil risquant de provoquer la détérioration de l'accumulateur et le mauvais fonctionnement de la batterie.

En outre, de par leur légèreté et leur faible encombrement, ces composants peuvent être intégrés sans difficulté dans une batterie d'accumulateurs.

De plus, tous les composants étant intégrés au sein d'une même batterie, ils sont tous soumis aux mêmes conditions de température, de sorte que les dérives des caractéristiques des diodes évoluent ensemble, ce qui assure un bon équilibre et une mesure précise quelle que soit la température.

## Revendications

1. Dispositif de mesure de tension pour batterie comprenant un accumulateur (Ai), ledit dispositif de mesure comportant :
- un générateur de courant alternatif (I1),
- au moins une première (D1ᵢ) et au moins une seconde (D2ᵢ) diodes mises en série, telles que ladite première diode (D1ᵢ) soit reliée au pôle positif (+) dudit accumulateur (Ai) par sa cathode et à la cathode de ladite seconde diode (D2ᵢ) par son anode, et ladite seconde diode (D2ᵢ) soit reliée au pôle négatif (-) dudit accumulateur (Ai) par son anode et à l'anode de ladite première diode (D1ᵢ) par sa cathode,
- un condensateur de lecture (Cl) relié au générateur de courant alternatif (I1) et au point milieu (N) entre lesdites première (D1ᵢ) et seconde (D2ᵢ) diodes, et à un moyen de détermination (3) de la tension aux bornes dudit accumulateur (Ai) à partir de la variation de tension au point milieu (N), **caracterisé en ce que** ledit moyen de détermination (3) comporte :
• une troisième (D3) et une quatrième (D4) diodes de redressement en série telles que l'anode de la troisième diode de redressement (D3) soit reliée à la cathode de la quatrième diode de redressement (D4) et audit condensateur de lecture (C1),
• un condensateur de filtrage (C2) relié d'une part à la cathode de la troisième diode de redressement (D3) et à l'anode de la quatrième diode de redressement (D4),
• une résistance (R) montée en parallèle du condensateur de filtrage (C2).

2. Dispositif de mesure selon la revendication 1, **caractérisé en ce que** lesdites première (D1ᵢ) et seconde (D2ᵢ) diodes présentent une tension de seuil sensiblement égale à 0,6 V.

3. Dispositif de mesure selon l'une des revendications 1 ou 2, **caractérisé en ce qu'**il comporte en outre un condensateur d'injection (Ci) relié au générateur de courant et au point milieu (N).

4. Dispositif de mesure de tension pour batterie comportant au moins deux accumulateurs (Ak) en série, **caractérisé en ce que** ledit dispositif comporte :
- un dispositif de mesure selon l'une quelconque des revendications 1 à 3 pour un des accumulateurs (Aj),
- une première (D1ₖ) et une seconde (D2ₖ) diodes en parallèle de chaque accumulateur (Ak),
- une pluralité de condensateurs de liaison (C1ₘ) reliant respectivement deux points milieu consécutifs (Nₖ), ladite pluralité de condensateurs de liaison (C1ₘ) étant montés en série.

5. Dispositif de mesure selon la revendication 4, **caractérisé en ce qu'**il comporte en outre un condensateur d'injection (Ci) relié au générateur de courant alternatif d'une part et à un point milieu (Nₖ) quelconque d'autre part.

6. Dispositif de mesure selon l'une quelconque des revendications précédentes, **caractérisé en ce que** les troisième (D3) et quatrième (D4) diodes de redressement sont configurées pour soustraire les tensions de seuil desdites première (D1, D1ᵢ) et seconde (D2, D2ᵢ) diodes du signal de tension traversant lesdites troisième (D3) et quatrième (D4) diodes de redressement.

7. Dispositif de mesure selon l'une quelconque des revendications précédentes, **caractérisé en ce qu'**il comporte au moins un condensateur de rappel (C3₁,C3₂,C3₃) monté en parallèle d'un nombre prédéterminé des condensateurs de liaison (C1ₘ).

8. Dispositif de mesure selon l'une quelconque des revendications précédentes, **caractérisé en ce que** le générateur de courant alternatif est réalisé par un générateur de tension et une résistance (R') montés en série, ledit générateur de tension générant un signal carré de fréquence de 100kHz et d'amplitude de 0 à 10 V.

9. Dispositif de contrôle comprenant un dispositif de mesure selon l'une quelconque des revendications précédentes, **caractérisé en ce qu'**il comprend un moyen de comparaison de la tension mesurée dudit accumulateur (Ai) à une tension de seuil prédéfinie et un dispositif de commande pour arrêter la décharge de la batterie lorsque ladite tension mesurée est inférieure à la tension de seuil prédéfinie.

10. Batterie d'accumulateurs comprenant un dispositif de contrôle selon la revendication 9.

11. Batterie selon la revendication 10, **caractérisée en ce que** ladite batterie est une batterie lithium-ion.

## Patentansprüche

1. Spannungsmessvorrichtung für Batterien, umfassend einen Akkumulator (Ai), wobei die Messvorrichtung Folgendes umfasst:
- einen Wechselstromerzeuger (I1),
- mindestens eine erste (D1ᵢ) und mindestens eine zweite (D2ᵢ) Diode, die derart in Reihe geschaltet sind, dass die erste Diode (D1ᵢ) mit dem positiven Pol (+) des Akkumulators (Ai) über ihre Kathode verbunden ist und mit der Kathode der zweiten Diode (D2ᵢ) über ihre Anode verbunden ist und dass die zweite Diode (D2ᵢ) mit dem negativen Pol (-) des Akkumulators (Aᵢ) über ihre Anode verbunden ist und mit der Anode der ersten Diode (D1ᵢ) über ihre Kathode verbunden ist,
- einen Lesekondensator (Cℓ), der mit dem Wechselstromerzeuger (I1) und dem Mittelpunkt (N) zwischen den ersten (D1ᵢ) und zweiten (D2ᵢ) Dioden verbunden ist und mit einem Mittel (3) zum Bestimmen der Spannung an den Klemmen des Akkumulators (Ai) ausgehend von der Spannungsschwankung am Mittelpunkt (N) verbunden ist,
**dadurch gekennzeichnet, dass** das Bestimmungsmittel (3) Folgendes umfasst:
- eine dritte (D3) und eine vierte (D4) Gleichrichterdiode, die derart in Reihe geschaltet sind, dass die Anode der dritten Gleichrichterdiode (D3) mit der Kathode der vierten Gleichrichterdiode (D4) und mit dem Lesekondensator (Cℓ) verbunden ist,
- einen Filterkondensator (C2), der einerseits mit der Kathode der dritten Gleichrichterdiode (D3) und mit der Anode der vierten Gleichrichterdiode (D4) verbunden ist,
- einen Widerstand (R), der zum Filterkondensator (C2) parallel geschaltet ist.

2. Messvorrichtung nach Anspruch 1, **dadurch gekennzeichnet, dass** die erste (D1ᵢ) und die zweite (D2ᵢ) Diode eine Schwellenspannung aufweisen, die im Wesentlichen gleich 0,6 V ist.

3. Messvorrichtung nach einem der Ansprüche 1 oder 2, **dadurch gekennzeichnet, dass** sie ferner einen Einkoppelkondensator (Ci) umfasst, der mit dem Stromerzeuger und dem Mittelpunkt (N) verbunden ist.

4. Spannungsmessvorrichtung für Batterien, umfassend mindestens zwei in Reihe geschaltete Akkumulatoren (Ak), **dadurch gekennzeichnet, dass** die Vorrichtung Folgendes umfasst:
- eine Messvorrichtung nach einem der Ansprüche 1 bis 3 für einen der Akkumulatoren (Aj),
- eine erste (D1ₖ) und eine zweite (D2ₖ) Diode parallel zu jedem Akkumulator (Ak),
- eine Vielzahl von Verbindungskondensatoren (C1ₘ), die jeweils zwei aufeinanderfolgende Mittelpunkte (Nk) verbinden, wobei die Vielzahl von Verbindungskondensatoren (C1ₘ) in Reihe geschaltet ist.

5. Messvorrichtung nach Anspruch 4, **dadurch gekennzeichnet, dass** sie ferner einen Einkoppelkondensator (Ci) umfasst, der mit dem Wechselstromerzeuger einerseits und mit einem beliebigen Mittelpunkt (Nₖ) andererseits verbunden ist.

6. Messvorrichtung nach einem der vorhergehenden Ansprüche, **dadurch gekennzeichnet, dass** die dritte (D3) und die vierte (D4) Gleichrichterdiode dazu konfiguriert sind, die Schwellenspannungen der ersten (D1, D1ᵢ) und zweiten (D2, D2ᵢ) Dioden von dem Spannungssignal abzuziehen, das durch die dritte (D3) und die vierte (D4) Gleichrichterdiode geht.

7. Messvorrichtung nach einem der vorhergehenden Ansprüche, **dadurch gekennzeichnet, dass** sie mindestens einen Rückstellkondensator (C3₁, C3₂, C3₃) umfasst, der zu einer vorherbestimmten Anzahl der Verbindungskondensatoren (C1ₘ) parallel geschaltet ist.

8. Messvorrichtung nach einem der vorhergehenden Ansprüche, **dadurch gekennzeichnet, dass** der Wechselstromerzeuger durch einen Spannungserzeuger und einen Widerstand (R') ausgebildet ist, die in Reihe geschaltet sind, wobei der Spannungserzeuger ein Frequenz-Rechtecksignal von 100 kHz und mit einer Amplitude von 0 bis 10 V erzeugt.

9. Steuervorrichtung, umfassend eine Messvorrichtung nach einem der vorhergehenden Ansprüche, **dadurch gekennzeichnet, dass** sie ein Mittel zum Vergleichen der Spannung, die von dem Akkumulator (Ai) gemessen wird, mit einer vordefinierten Schwellenspannung und eine Steuervorrichtung, um das Entladen der Batterie anzuhalten, wenn die gemessene Spannung kleiner als die vordefinierte Schwellenspannung ist, umfasst.

10. Akkumulatorenbatterie, umfassend eine Steuervorrichtung nach Anspruch 9.

11. Batterie nach Anspruch 10, **dadurch gekennzeichnet, dass** die Batterie eine Lithium-Ionen-Batterie ist.

## Claims

1. Voltage measuring device for a battery comprising an accumulator (Ai), said measuring device comprising:
- an alternating current generator (I1),
- at least one first (D1ᵢ) and at least one second (D2ᵢ) diodes connected in series, such that said first diode (D1ᵢ) is linked to the positive pole (+) of said accumulator (Ai) by its cathode and to the cathode of said second diode (D2ᵢ) by its anode, and said second diode (D2ᵢ) is linked to the negative pole (-) of said accumulator (Ai) by its anode and to the anode of said first diode (D1ᵢ) by its cathode,
- a reading capacitor (Cℓ) linked to the alternating current generator (I1) and to the mid-point (N) between said first (D1ᵢ) and second (D2ᵢ) diodes, and to a means (3) for determining the voltage at the terminals of said accumulator (Ai) based on the voltage variation at the mid-point (N), **characterized in that** said determination means (3) comprises:
• a third (D3) and a fourth (D4) rectifying diodes in series such that the anode of the third rectifying diode (D3) is linked to the cathode of the fourth rectifying diode (D4) and to said reading capacitor (Cℓ),
• a filtering capacitor (C2) linked on the one hand to the cathode of the third rectifying diode (D3) and to the anode of the fourth rectifying diode (D4),
• a resistor (R) mounted in parallel with the filtering capacitor (C2).

2. Measuring device according to Claim 1, **characterized in that** said first (D1ᵢ) and second (D2ᵢ) diodes have a threshold voltage substantially equal to 0.6 V.

3. Measuring device according to either of Claims 1 and 2, **characterized in that** it also comprises an injection capacitor (Ci) linked to the current generator and to the mid-point (N).

4. Voltage measuring device for a battery comprising at least two accumulators (Ak) in series, **characterized in that** said device comprises:
- a measuring device according to any one of Claims 1 to 3 for one of the accumulators (Aj),
- a first (D1ₖ) and a second (D2ₖ) diodes in parallel with each accumulator (Ak),
- a plurality of link capacitors (C1ₘ) respectively linking two consecutive mid-points (Nₖ), said plurality of link capacitors (C1ₘ) being mounted in series.

5. Measuring device according to Claim 4, **characterized in that** it also comprises an injection capacitor (Ci) linked to the alternating current generator on the one hand and to any mid-point (Nₖ) on the other hand.

6. Measuring device according to any one of the preceding claims, **characterized in that** the third (D3) and fourth (D4) rectifying diodes are configured to subtract the threshold voltages of said first (D1, D1ᵢ) and second (D2, D2ᵢ) diodes from the voltage signal passing through said third (D3) and fourth (D4) rectifying diodes.

7. Measuring device according to any one of the preceding claims, **characterized in that** it comprises at least one booster capacitor (C3₁, C3₂, C3₃) mounted in parallel with a predetermined number of the link capacitors (C1ₘ).

8. Measuring device according to any one of the preceding claims, **characterized in that** the alternating current generator is implemented by a voltage generator and a resistor (R') which are mounted in series, said voltage generator generating a square signal with a frequency of 100 kHz and an amplitude of 0 to 10 V.

9. Monitoring device comprising a measuring device according to any one of the preceding claims, **characterized in that** it comprises a means for comparing the measured voltage of said accumulator (Ai) to a predefined threshold voltage and a control device for stopping the discharging of the battery when said measured voltage is below the predefined threshold voltage.

10. Battery of accumulators comprising a monitoring device according to Claim 9.

11. Battery according to Claim 10, **characterized in that** said battery is a lithium-ion battery.
